# EUROPEAN PATENT SPECIFICATION

(11) **EP 3 012 353 B1**
(45) Date of publication and mention of the grant of the patent: **08.03.2017**
(21) Application number: 14813873.8
(22) Date of filing: 20.03.2014
(51) Int. Cl.: C30B 29/28, C30B 15/20

(54) **GARNET-TYPE SINGLE CRYSTAL AND PRODUCTION METHOD THEREFOR**
GRANATARTIGER EINKRISTALL UND HERSTELLUNGSVERFAHREN DAFÜR
MONOCRISTAL DE TYPE GRENAT, ET PROCÉDÉ DE FABRICATION DE CELUI-CI

(30) Priority: 17.06.2013 JP 2013126314
(43) Date of publication of application: 27.04.2016
(73) Proprietor: Sumitomo Metal Mining Co., Ltd., Tokyo 105-8716 (JP)
(72) Inventor: MATSUI, Masayoshi, Ome-shi, Tokyo 198-8601 (JP); TATSUMIYA, Kazuki, Ome-shi, Tokyo 198-8601 (JP); ISHIDA, Fumiaki, Ome-shi, Tokyo 198-8601 (JP)
(74) Representative: TBK
(86) International application number: PCT/JP2014/057757
(87) International publication number: WO 2014/203577

(56) References cited:
- EP-A1- 2 492 379
- EP-A1- 2 562 296
- EP-A1- 2 599 899
- WO-A1-2012/014796
- JP-A- 2002 293 693
- D.A.PAWLAK ET AL.: 'Growth of Tb-Sc-Al garnet single crystals by the micro-pulling down method' JOURNAL OF CRYSTAL GROWTH vol. 226, 13 June 2001, pages 341 - 347, XP 027247892

## Description

### TECHNICAL FIELD

The present invention relates to a garnet single crystal and a method for producing a garnet single crystal by a Czochralski process. Particularly, the present invention relates to a high-quality, transparent terbium-scandium-aluminium garnet single crystal with suppressed cell growth that would otherwise lead to partially inhomogeneous crystal composition, and a method for producing the garnet single crystal.

### BACKGROUND ART

An optical isolator, which includes a Faraday rotator configured to rotate the plane of polarization of incident light upon a magnetic-field application, has been used recently not only in optical communications but also in fiber laser cutting and welding machines.

Heretofore, as a material of a Faraday rotator used in such an optical isolator, a terbium-scandium-aluminium garnet single crystal (TSAG: Tb₃S_{C2}Al₃O₁₂) has been known (Non Patent Document 1).

Moreover, Patent Document 1 discloses that a high-quality garnet single crystal is relatively easily obtained by setting the composition of a terbium-scandium-aluminium garnet single crystal to (Tb₃₋ₓScₓ)Sc₂Al₃O₁₂ (provided that 0.1≤x<0.3).

Further, Patent Document 2 discloses a high-quality garnet single crystal produced without cracks by setting the composition of a terbium-scandium-aluminium garnet single crystal to (Tb₃₋ₓScₓ)(Sc_{2-y}Al_{y})Al₃O_{12-z} (provided that 0<x<0.1).

### Conventional Art Documents

### Patent Documents

Patent Document 1: Japanese Patent Application Publication No. 2002-293693
Patent Document 2: Japanese Patent No. 4943566

### Non Patent Document

Non Patent Document 1: Yoshikawa and five others "Czochralski growth of Tb3Sc2Al3O12 single crystal for Faraday rotator," Materials Research Bulletin, 2002, vol. 37, p.p. 1-10

### SUMMARY OF THE INVENTION

### Problems to be Solved by the Invention

Meanwhile, the terbium-scandium-aluminium garnet single crystals described in these documents are transparent at a laser wavelength of around 1 µm.

However, when a seed crystal is brought into contact with a raw-material melt and a solid garnet single crystal is grown by the Czochralski process, this sometimes results in such a cell growth that causes a part of the crystal composition to be significantly inhomogeneous due to a segregation phenomenon that some constituent element(s) of the garnet single crystal exit into the raw-material melt. In addition, the resulting crystal cannot be used as a Faraday rotator because the cell growth portion having inhomogeneous crystal composition causes incident laser light to scatter.

The present invention has been made in view of such problems as described above. An object of the present invention is to provide a high-quality, transparent terbium-scandium-aluminium garnet single crystal with suppressed cell growth that would otherwise lead to partially inhomogeneous crystal composition, and also to provide a method for producing the garnet single crystal.

### Means for Solving the Problems

Accordingly, the present inventors have earnestly studied to achieve the above object. As a result, the inventors have found out that a high-quality, transparent terbium-scandium-aluminium garnet single crystal with the above-described cell growth suppressed is obtained by selecting the terbium-scandium-aluminium garnet single crystal composition from a composition range different from those of Patent Documents 1 and 2. Moreover, the inventors have found out that a Czochralski process performed under specified conditions such as the number of rotations of a seed crystal and the rate of pulling the seed crystal makes it possible to reliably produce the garnet single crystal with the cell growth suppressed.

Specifically, a first aspect according to the present invention is a garnet single crystal characterized in that the garnet single crystal is represented by the following general formula:

(Tb₃₋ₓScₓ)(SC_{2-y}Al_{y})Al₃O_{12-z} (1)

(where x satisfies 0.11≤x≤0.14, and y satisfies 0.17≤y≤0.23).

A second aspect of the present invention is a method for producing a garnet single crystal using a growth furnace including a crucible in a cylindrical chamber by a Czochralski process for growing a garnet single crystal by bringing a seed crystal into contact with a raw-material melt in the crucible and pulling, while rotating, the seed crystal, characterized in that the production method comprises:
preparing the raw-material melt by filling the crucible with a mixture powder containing 20.9 to 21.2% by mole terbium oxide, 32.7 to 33.3% by mole scandium oxide, and the balance of aluminium oxide and unavoidable impurities, followed by melting of the mixture powder; and
growing the garnet single crystal according to the first aspect, while supplying an inert gas into the chamber, by setting conditions such that the number of rotations of the seed crystal is 20 rpm or less, and a rate of pulling the seed crystal is 0.8 mm/h or less.

Next, a third aspect of the present invention is the method for producing a garnet single crystal according to the second aspect, characterized in that the conditions are set such that
the number of rotations of the seed crystal is from 5 rpm or more to 20 rpm or less, and
the rate of pulling the seed crystal is from 0.3 mm/h or more to 0.8 mm/h or less.

A fourth aspect of the present invention is the method for producing a garnet single crystal according to the second aspect, characterized in that the inert gas is supplied into the chamber at a flow rate of from 3 L/min or more to 6 L/min or less.

A fifth aspect of the present invention is the method for producing a garnet single crystal according to the third aspect, characterized in that the inert gas is supplied into the chamber at a flow rate of from 3 L/min or more to 6 L/min or less.

Moreover, a sixth aspect of the present invention is the method for producing a garnet single crystal according to any one of the second to the fifth aspects, characterized in that the inert gas is a nitrogen gas.

Meanwhile, as follows, the present inventors presume the reason why the above-described cell growth is suppressed by selecting the terbium-scandium-aluminium garnet single crystal composition from the composition range of (Tb₃₋ₓScₓ) (Sc_{2-y}Al_{y})Al₃O_{12-z} (where x satisfies 0.11≤x≤0.14, and y satisfies 0.17≤y≤0.23), which is different from those of Patent Documents 1 and 2.

Specifically, based on the crystal composition, a mixture powder containing 20.9 to 21.2% by mole terbium oxide, 32.7 to 33.3% by mole scandium oxide, and the balance of aluminium oxide and unavoidable impurities is filled into a crucible and melted to prepare a raw-material melt. Then, while an inert gas is supplied into the chamber, the number of rotations of a seed crystal is set to 20 rpm or less, and the rate of pulling the seed crystal is set to 0.8 mm/h or less to maintain the composition of the raw-material melt after the crystal growth is started and during the growth in such a way that the crystal has a composition of (Tb₃₋ₓScₓ)(Sc_{2-y}Al_{y})Al₃O_{12-z} (x satisfies 0.11≤x≤0.14, and y satisfies 0.17≤y≤0.23). This presumably suppresses the phenomenon that only a certain element(s) exit in a large amount into the raw-material melt during the crystallization.

### Effects of the Invention

The garnet single crystal according to the present invention is a crystal with suppressed cell growth that would otherwise lead to partially inhomogeneous crystal composition. Thus, the present invention provides, as an effect, the garnet single crystal with no cell growth portion, which is efficiently usable for Faraday rotators and so forth. Brief Description of Drawings

[Fig. 1] Fig. 1 is a schematic configuration explanatory drawing of a production apparatus used in a method for producing a garnet single crystal according to the present invention.
[Fig. 2] Fig. 2 is an explanatory drawing showing a crystal top portion and a crystal bottom portion of a garnet single crystal according to the present invention.

### MODES FOR PRACTICING THE INVENTION

Hereinafter, embodiments of the present invention will be described in detail with reference to the drawings.

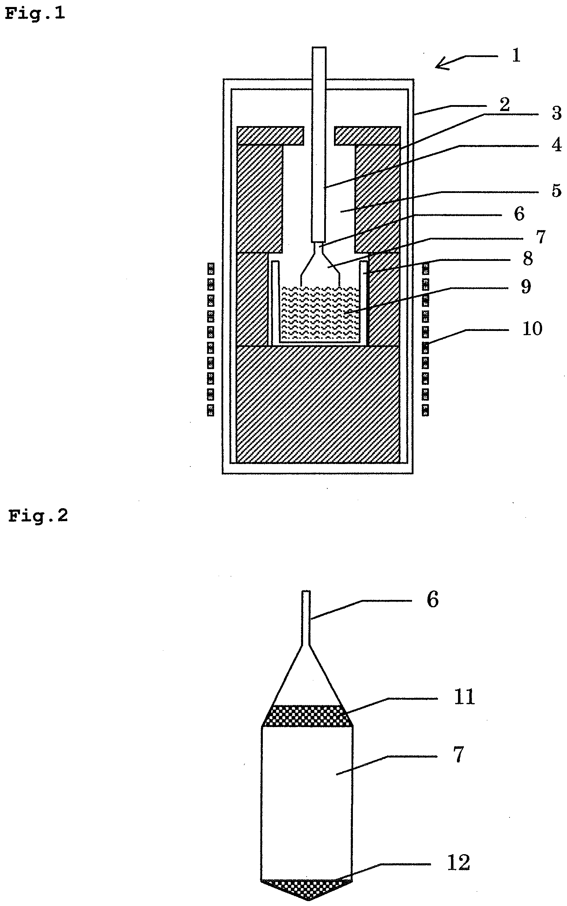

Fig. 1 is an explanatory drawing showing a schematic configuration of a production apparatus used in a method for producing a garnet single crystal according to the present invention. The production apparatus includes a growth furnace 1 for producing a garnet single crystal by the known Czochralski process. A structure of the growth furnace 1 will be briefly described. The growth furnace 1 has a cylindrical chamber 2, an RF coil 10 provided outside the chamber 2, and an iridium crucible 8 disposed inside the chamber 2. Note that although the dimensions of the growth furnace 1 depend on the size of a garnet single crystal to be produced, the growth furnace 1 has a diameter of approximately 1 m, and a height of approximately 1 m, as examples.

Moreover, the growth furnace 1 is provided with two openings (not shown). An inert gas is supplied or discharged through these openings. During crystal growth, the chamber 2 is filled with such an inert gas. Note that, inside the growth furnace 1, a thermometer (not shown) configured to measure a temperature is provided below a bottom portion of the crucible 8.

Further, the RF coil 10 is made from a copper tube, and an electric power inputted thereto is controlled by an unillustrated controller such that the crucible 8 is subjected to high-frequency heating and the temperature is adjusted. Furthermore, inside the RF coil 10, multiple heat insulators 3 are disposed in the chamber 2. A space surrounded by the heat insulators 3 forms a hot zone 5. Additionally, a temperature gradient is formed in a vertical direction within the hot zone 5 by controlling the amount of the electric power inputted to the RF coil 10. Note that the heat insulators 3 are made of a refractory material having a high melting point.

Moreover, the crucible 8 is formed in a cup shape whose bottom portion is disposed on the heat insulator 3 and supported by the heat insulator 3. Further, above the crucible 8 is provided a pulling rod 4 configured to hold and pull a seed crystal and a grown garnet single crystal. The pulling rod 4 is rotatable about its axis.

Here, the crucible 8 is to be filled with raw materials. The crucible 8 is disposed in the chamber 2 of the growth furnace 1, and heated with the RF coil 10 to melt the raw materials. Then, a seed crystal 6 is brought into contact with a raw-material melt 9, and the temperature is gradually decreased, while the pulling rod 4 is gradually pulled up at the same time. Thereby, the raw-material melt 9 is sequentially crystallized from a lower portion of the seed crystal. Further, the electric power inputted to the RF coil 10 is adjusted so that a garnet single crystal having a desired diameter can be grown.

Note that a series of temperature monitorings for the garnet single crystal growth are carried out through the measurements with the unillustrated thermometer provided below the bottom portion of the crucible 8.

Additionally, the garnet single crystal uses, as the raw materials, a terbium oxide (Tb₄O₇) powder, a scandium oxide (Sc₂O₃) powder, and an aluminium oxide (Al₂O₃) powder. The blending ratios of these raw-material powders are determined depending on the composition of a single crystal to be grown and the growth conditions.

Furthermore, in the present invention, in order to obtain a garnet single crystal having a composition of the following general formula:

(Tb₃₋ₓScₓ)(SC_{2-y}Al_{y})Al₃O_{12-z} (1)

(where x satisfies 0.11≤x≤0.14, and y satisfies 0.17≤y≤0.23), used are: a seed crystal made of YAG; and raw-material powders of a terbium oxide powder, a scandium oxide powder, and an aluminium oxide powder mixed using a vibrating mixer or the like at blending ratios of 20.9 to 21.2% by mole, 32.7 to 33.3% by mole, and 45.4 to 46.4% by mole, respectively. A terbium-scandium-aluminium garnet single crystal is grown in an inert gas atmosphere by setting conditions such that the number of rotations of the seed crystal is 20 rpm or less, preferably from 5 rpm or more to 20 rpm or less, and that the rate of pulling the seed crystal is 0.8 mm/h or less, preferably from 0.3 mm/h or more to 0.8 mm/h or less.

Note that if the number of rotations of the seed crystal exceeds 20 rpm, the above-described cell growth occurs, and that if the rate of pulling the seed crystal exceeds 0.8 mm/h also, the cell growth occurs. On the other hand, if the number of rotations of the seed crystal is less than 5 rpm, it is sometimes difficult to control the shape of a target garnet single crystal; if the rate of pulling the seed crystal is less than 0.3 mm/h, the productivity of a target garnet single crystal is reduced. Hence, the conditions are preferably set such that the number of rotations of the seed crystal is from 5 rpm or more to 20 rpm or less, and that the rate of pulling the seed crystal is from 0.3 mm/h or more to 0.8 mm/h or less, as described above.

Meanwhile, the inert gas to be supplied into the chamber is not directly related to the occurrence of the cell growth, and hence the flow rate may be any value. Nevertheless, the condition is preferably from 3 L/min or more to 6 L/min or less as described above. If the flow rate of the inert gas is less than 3 L/min, the temperature distribution within the hot zone 5 becomes too narrow, making it difficult to control the garnet single crystal growth in some cases. In contrast, if the flow rate of the inert gas exceeds 6 L/min, the temperature distribution within the hot zone 5 becomes too broad, making it difficult to control the crystal growth in some cases, as well. Hence, the condition regarding the flow rate of the inert gas to be supplied into the chamber is preferably from 3 L/min or more to 6 L/min or less.

Note that, regarding the inert gas, as long as the gas is inert like argon, the effects of the present invention are obtained. Nevertheless, a nitrogen gas is more preferable because it is less expensive.

### Examples

Hereinafter, Examples of the present invention will be described specifically together with Comparative Examples.

### Example 1

An iridium crucible having a diameter of 50 mm and a depth of 50 mm was loaded with a mixture powder of a terbium oxide powder (purity: 99.99%), a scandium oxide powder (purity: 99.99%), and an aluminium oxide powder (purity: 99.99%).

The blending ratios of the terbium oxide powder, the scandium oxide powder, and the aluminium oxide powder based on a total number of moles were such that: the terbium oxide powder accounted for 21.2% by mole; the scandium oxide powder accounted for 33.3% by mole; and the aluminium oxide powder accounted for 45.5% by mole.

The crucible loaded with the mixture powder was placed on the heat insulator located at the bottom portion in the chamber of the growth furnace. After the chamber was closed, an electric power was inputted to the RF coil to heat the crucible, so that the mixture powder was melted. Subsequently, a tip end of a rod-shaped seed crystal attached to the pulling rod and made of YAG (yttrium aluminium garnet) having a diameter of 5 mm and a length of 70 mm was dipped into the raw-material melt. Thereafter, the seed crystal was pulled up while being rotated under conditions where the number of rotations was 10 rpm and the pulling rate was 0.5 mm/h. In this event, a nitrogen gas was supplied into the chamber at a flow rate of 4 L/min, and the crystal was pulled under atmospheric pressure. As a result, a terbium-scandium-aluminium garnet single crystal having a maximum diameter of 25 mm and a length of 50 mm was obtained without cracks.

After that, the obtained garnet single crystal was interposed between two polarizing plates orthogonal to each other for the observation. As a result, no cell growth was observed.

Next, samples were collected from positions at a crystal top portion 11 and a crystal bottom portion 12, shown in Fig. 2, of the obtained garnet single crystal. A chemical analysis was conducted using an inductively coupled plasma to examine the composition. As a result, the composition was: Tb=2.86, Sc=1.92, and Al=3.22 at the crystal top portion 11; and Tb=2.87, Sc=1.96, and Al=3.17 at the crystal bottom portion 12.

Incidentally, the values of x and y in the garnet single crystal according to Example 1 represented by the above-described chemical formula (1): (Tb₃₋ₓScₓ)(Sc_{2-y}Al_{y})Al₃O_{12-z} were:
"x=0.14" and "y=0.22" at the crystal top portion 11; and
"x=0.13" and "y=0.17" at the crystal bottom portion 12. It was verified that the requirements of "0.11≤x≤0.14" and "0.17≤y≤0.23" were satisfied.

Note that Tables 1-1, 1-2, and 1-3 below collectively show "the blending ratios of the raw material powders," "the composition of the single crystal," "the values of x and y," "the nitrogen gas flow rate," "the number of rotations of the seed crystal," "the rate of pulling the seed crystal," and "whether the cell growth was present or absent" in Examples 1 to 4 and Comparative Examples 1 to 4.

### Example 2

A terbium-scandium-aluminium garnet single crystal was grown in the same manner as in Example 1, except for the blending ratios of the terbium oxide powder, the scandium oxide powder, and the aluminium oxide powder based on a total number of moles: the terbium oxide powder accounted for 21.1% by mole; the scandium oxide powder accounted for 33.2% by mole; and the aluminium oxide powder accounted for 45.7% by mole. Thus, a garnet single crystal having a maximum diameter of 25 mm and a length of 50 mm was obtained without cracks.

Next, as in Example 1, the obtained garnet single crystal was interposed between two polarizing plates orthogonal to each other for the observation. As a result, no cell growth was observed.

Further, samples were collected from positions at the crystal top portion 11 and the crystal bottom portion 12 of the garnet single crystal according to Example 2. A chemical analysis was conducted using an inductively coupled plasma to examine the composition. As a result, the composition was: Tb=2.87, Sc=1.93, and Al=3.20 at the crystal top portion 11; and Tb=2.87, Sc=1.93, and Al=3.20 at the crystal bottom portion 12.

Furthermore, the values of x and y in the garnet single crystal according to Example 2 represented by the chemical formula (1) : (Tb₃₋ₓScₓ)(Sc_{2-y}Al_{y})Al₃O_{12-z} were:
"x=0.13" and "y=0.20" at the crystal top portion 11; and
"x=0.13" and "y=0.20" at the crystal bottom portion 12. It was verified that the requirements of "0.11≤x≤0.14" and "0.17≤y≤0.23" were satisfied.

### Example 3

A terbium-scandium-aluminium garnet single crystal was grown in the same manner as in Example 1, except for the blending ratios of the terbium oxide powder, the scandium oxide powder, and the aluminium oxide powder based on a total number of moles: the terbium oxide powder accounted for 21.1% by mole; the scandium oxide powder accounted for 33.1% by mole; and the aluminium oxide powder accounted for 45.8% by mole. Thus, a garnet single crystal having a maximum diameter of 25 mm and a length of 50 mm was obtained without cracks.

Next, as in Example 1, the obtained garnet single crystal was interposed between two polarizing plates orthogonal to each other for the observation. As a result, no cell growth was observed.

Further, samples were collected from positions at the crystal top portion 11 and the crystal bottom portion 12 of the garnet single crystal according to Example 3. A chemical analysis was conducted using an inductively coupled plasma to examine the composition. As a result, the composition was: Tb=2.89, Sc=1.88, and Al=3.23 at the crystal top portion 11; and Tb=2.87, Sc=1.96, and Al=3.17 at the crystal bottom portion 12.

Furthermore, the values of x and y in the garnet single crystal according to Example 3 represented by the chemical formula (1) : (Tb₃₋ₓScₓ)(Sc_{2-y}Al_{y})Al₃O_{12-z} were:
"x=0.11" and "y=0.23" at the crystal top portion 11; and
"x=0.13" and "y=0.17" at the crystal bottom portion 12. It was verified that the requirements of "0.111≤x≤0.14" and "0.17≤y≤0.23" were satisfied.

### Example 4

A terbium-scandium-aluminium garnet single crystal was grown in the same manner as in Example 1, except for the blending ratios of the terbium oxide powder, the scandium oxide powder, and the aluminium oxide powder based on a total number of moles: the terbium oxide powder accounted for 20.9% by mole; the scandium oxide powder accounted for 32.7% by mole; and the aluminium oxide powder accounted for 46.4% by mole. Thus, a garnet single crystal having a maximum diameter of 25 mm and a length of 50 mm was obtained without cracks.

Next, as in Example 1, the obtained garnet single crystal was interposed between two polarizing plates orthogonal to each other for the observation. As a result, no cell growth was observed.

Further, samples were collected from positions at the crystal top portion 11 and the crystal bottom portion 12 of the garnet single crystal according to Example 4. A chemical analysis was conducted using an inductively coupled plasma to examine the composition. As a result, the composition was: Tb=2.88, Sc=1.90, and Al=3.22 at the crystal top portion 11; and Tb=2.87, Sc=1.94, and Al=3.19 at the crystal bottom portion 12.

Furthermore, the values of x and y in the garnet single crystal according to Example 4 represented by the chemical formula (1) : (Tb₃₋ₓScₓ)(Sc_{2-y}Al_{y})Al₃O_{12-z} were:
"x=0.12" and "y=0.22" at the crystal top portion 11; and
"x=0.13" and "y=0.19" at the crystal bottom portion 12. It was verified that the requirements of "0.11≤x≤0.14" and "0.17≤y≤0.23" were satisfied.

### Comparative Example 1

A terbium-scandium-aluminium garnet single crystal was grown in the same manner as in Example 1, except for the blending ratios of the terbium oxide powder, the scandium oxide powder, and the aluminium oxide powder based on a total number of moles: the terbium oxide powder accounted for 20.9% by mole; the scandium oxide powder accounted for 35.5% by mole (outside the range of 32.7 to 33.3% by mole); and the aluminium oxide powder accounted for 43.6% by mole. Thus, a garnet single crystal having a maximum diameter of 25 mm and a length of 50 mm was obtained without cracks.

Next, as in Example 1, the obtained garnet single crystal was interposed between two polarizing plates orthogonal to each other for the observation. As a result, a cell growth was observed.

Further, a sample was collected from a position at the crystal top portion 11 of the garnet single crystal according to Comparative Example 1. A chemical analysis was conducted using an inductively coupled plasma to examine the composition. As a result, the composition was: Tb=2.85, Sc=1.99, and Al=3.16.

Note that the values of x and y in the garnet single crystal according to Comparative Example 1 represented by the chemical formula (1) : (Tb₃₋ₓScₓ)(Sc_{2-y}Al_{y})Al₃O_{12-z} were: "x=0.15" and "y=0.16". It was verified that the requirements of "0.11≤x≤0.14" and "0.17≤y≤0.23" were not satisfied.

### Comparative Example 2

A terbium-scandium-aluminium garnet single crystal was grown in the same manner as in Example 1, except for the blending ratios of the terbium oxide powder, the scandium oxide powder, and the aluminium oxide powder based on a total number of moles: the terbium oxide powder accounted for 21.0% by mole; the scandium oxide powder accounted for 32.4% by mole (outside the range of 32.7 to 33.3% by mole); and the aluminium oxide powder accounted for 46.6% by mole. Thus, a garnet single crystal having a maximum diameter of 25 mm and a length of 50 mm was obtained without cracks.

Next, as in Example 1, the obtained garnet single crystal was interposed between two polarizing plates orthogonal to each other for the observation. As a result, a cell growth was observed.

Further, a sample was collected from a position at the crystal top portion 11 of the garnet single crystal according to Comparative Example 2. A chemical analysis was conducted using an inductively coupled plasma to examine the composition. As a result, the composition was: Tb=2.87, Sc=1.88, and Al=3.25.

Note that the values of x and y in the garnet single crystal according to Comparative Example 2 represented by the chemical formula (1) : (Tb₃₋ₓScₓ)(Sc_{2-y}Al_{y})Al₃O_{12-z} were: "x=0.13" and "y=0.25". It was verified that although the requirement of "0.11≤x≤0.14" was satisfied, the requirement of "0.17≤y≤<0.23" was not satisfied.

### Comparative Example 3

A terbium-scandium-aluminium garnet single crystal was grown in the same manner as in Example 1, except for the blending ratios of the terbium oxide powder, the scandium oxide powder, and the aluminium oxide powder based on a total number of moles: the terbium oxide powder accounted for 21.5% by mole (outside the range of 20.9 to 21.2% by mole); the scandium oxide powder accounted for 33.3% by mole; and the aluminium oxide powder accounted for 45.2% by mole. Thus, a garnet single crystal having a maximum diameter of 25 mm and a length of 50 mm was obtained without cracks.

Next, as in Example 1, the obtained garnet single crystal was interposed between two polarizing plates orthogonal to each other for the observation. As a result, a cell growth was observed.

Further, a sample was collected from a position at the crystal top portion 11 of the garnet single crystal according to Comparative Example 3. A chemical analysis was conducted using an inductively coupled plasma to examine the composition. As a result, the composition was: Tb=2.91, Sc=1.87, and Al=3.22.

Note that the values of x and y in the garnet single crystal according to Comparative Example 3 represented by the chemical formula (1) : (Tb₃₋ₓScₓ)(Sc_{2-y}Al_{y})Al₃O_{12-z} were: "x=0.09" and "y=0.22". It was verified that although the requirement of "0.17≤y≤0.23" was satisfied, the requirement of "0.11≤x≤0.14" was not satisfied.

### Comparative Example 4

A terbium-scandium-aluminium garnet single crystal was grown in the same manner as in Example 1, except for the blending ratios of the terbium oxide powder, the scandium oxide powder, and the aluminium oxide powder based on a total number of moles: the terbium oxide powder accounted for 20.6% by mole (outside the range of 20.9 to 21.2% by mole); the scandium oxide powder accounted for 32.7% by mole; and the aluminium oxide powder accounted for 46.7% by mole. Thus, a garnet single crystal having a maximum diameter of 25 mm and a length of 50 mm was obtained without cracks.

Next, as in Example 1, the obtained garnet single crystal was interposed between two polarizing plates orthogonal to each other for the observation. As a result, a cell growth was observed.

Further, a sample was collected from a position at the crystal top portion 11 of the garnet single crystal according to Comparative Example 4. A chemical analysis was conducted using an inductively coupled plasma to examine the composition. As a result, the composition was: Tb=2.85, Sc=1.90, and Al=3.25.

Note that the values of x and y in the garnet single crystal according to Comparative Example 4 represented by the chemical formula (1) : (Tb₃₋ₓScₓ)(Sc_{2-y}Al_{y})Al₃O_{12-z} were: "x=0.15" and "y=0.25". It was verified that the requirements of "0.11≤x≤0.14" and "0.17≤y≤0.23" were not satisfied.

**[Table 1-1]**

| | | Tb₄O₇ | Sc₂O₃ | Al₂O₃ | Total |
|---|---|---|---|---|---|
| Example 1 | crystal top portion | 21.2 | 33.3 | 45.5 | 100.0 |
| | crystal bottom portion | | | | |
| Example 2 | crystal top portion | 21.1 | 33.2 | 45.7 | 100.0 |
| | crystal bottom portion | | | | |
| Example 3 | crystal top portion | 21.1 | 33.1 | 45.8 | 100.0 |
| | crystal bottom portion | | | | |
| Example 4 | crystal top portion | 20.9 | 32.7 | 46.4 | 100.0 |
| | crystal bottom portion | | | | |
| Comparative | crystal top portion | 20.9 | 35.5 | 43.6 | 100.0 |
| Example 1 | crystal bottom portion | | | | |
| Comparative | crystal top portion | 21.0 | 32.4 | 46.6 | 100.0 |
| Example 2 | crystal bottom portion | | | | |
| Comparative | crystal top portion | 21.5 | 33.3 | 45.2 | 100.0 |
| Example 3 | crystal bottom portion | | | | |
| Comparative | crystal top portion | 20.6 | 32.7 | 46.7 | 100.0 |
| Example 4 | crystal bottom portion | | | | |

**[Table 1-2]**

| | | Tb | Sc | Al | x | y |
|---|---|---|---|---|---|---|
| Example 1 | crystal top portion | 2.86 | 1.92 | 3.22 | 0.14 | 0.22 |
| | crystal bottom portion | 2.87 | 1.96 | 3.17 | 0.13 | 0.17 |
| Example 2 | crystal top portion | 2.87 | 1.93 | 3.20 | 0.13 | 0.20 |
| | crystal bottom portion | 2.87 | 1.93 | 3.20 | 0.13 | 0.20 |
| Example 3 | crystal top portion | 2.89 | 1.88 | 3.23 | 0.11 | 0.23 |
| | crystal bottom portion | 2.87 | 1.96 | 3.17 | 0.13 | 0.17 |
| Example 4 | crystal top portion | 2.88 | 1.90 | 3.22 | 0.12 | 0.22 |
| | crystal bottom portion | 2.87 | 1.94 | 3.19 | 0.13 | 0.19 |
| Comparative | crystal top portion | 2.85 | 1.99 | 3.16 | 0.15 | 0.16 |
| Example 1 | crystal bottom portion | | | | | |
| Comparative | crystal top portion | 2.87 | 1.88 | 3.25 | 0.13 | 0.25 |
| Example 2 | crystal bottom portion | | | | | |
| Comparative | crystal top portion | 2.91 | 1.87 | 3.22 | 0.09 | 0.22 |
| Example 3 | crystal bottom portion | | | | | |
| Comparative | crystal top portion | 2.85 | 1.90 | 3.25 | 0.15 | 0.25 |
| Example 4 | crystal bottom portion | | | | | |

**[Table 1-3]**

| | | N₂ | Number of rotations | Rate | Cell growth |
|---|---|---|---|---|---|
| Example 1 | crystal top portion | 4 | 10 | 0.5 | absent |
| | crystal bottom portion | | | | |
| Example 2 | crystal top portion | 4 | 10 | 0.5 | absent |
| | crystal bottom portion | | | | |
| Example 3 | crystal top portion | 4 | 10 | 0.5 | absent |
| | crystal bottom portion | | | | |
| Example 4 | crystal top portion | 4 | 10 | 0.5 | absent |
| | crystal bottom portion | | | | |
| Comparative | crystal top portion | 4 | 10 | 0.5 | present |
| Example 1 | crystal bottom portion | | | | |
| Comparative | crystal top portion | 4 | 10 | 0.5 | present |
| Example 2 | crystal bottom portion | | | | |
| Comparative | crystal top portion | 4 | 10 | 0.5 | present |
| Example 3 | crystal bottom portion | | | | |
| Comparative | crystal top portion | 4 | 10 | 0.5 | present |
| Example 4 | crystal bottom portion | | | | |

### Example 5

A terbium-scandium-aluminium garnet single crystal was grown in the same manner as in Example 1, except that the seed crystal was rotated under a condition where the number of rotations was 20 rpm (a critical value in the range of from 5 rpm or more to 20 rpm or less). Thus, a garnet single crystal having a maximum diameter of 25 mm and a length of 50 mm was obtained without cracks.

Next, as in Example 1, the obtained garnet single crystal was interposed between two polarizing plates orthogonal to each other for the observation. As a result, no cell growth was observed.

### Example 6

A terbium-scandium-aluminium garnet single crystal was grown in the same manner as in Example 1, except that the seed crystal was pulled up under a condition where the pulling rate was 0.3 mm/h (a critical value in the range of from 0.3 mm/h or more to 0.8 mm/h or less). Thus, a garnet single crystal having a maximum diameter of 25 mm and a length of 50 mm was obtained without cracks.

Next, as in Example 1, the obtained garnet single crystal was interposed between two polarizing plates orthogonal to each other for the observation. As a result, no cell growth was observed.

### Example 7

A terbium-scandium-aluminium garnet single crystal was grown in the same manner as in Example 1, except that the seed crystal was pulled up under a condition where the pulling rate was 0.8 mm/h (a critical value in the range of from 0.3 mm/h or more to 0.8 mm/h or less). Thus, a garnet single crystal having a maximum diameter of 25 mm and a length of 50 mm was obtained without cracks.

Next, as in Example 1, the obtained garnet single crystal was interposed between two polarizing plates orthogonal to each other for the observation. As a result, no cell growth was observed.

### Example 8

A terbium-scandium-aluminium garnet single crystal was grown in the same manner as in Example 1, except that the nitrogen gas was supplied into the chamber at a flow rate of 6 L/min (a critical value in the range of from 3 L/min or more to 6 L/min or less). Thus, a garnet single crystal having a maximum diameter of 25 mm and a length of 50 mm was obtained without cracks.

Next, as in Example 1, the obtained garnet single crystal was interposed between two polarizing plates orthogonal to each other for the observation. As a result, no cell growth was observed.

### Example 9

A terbium-scandium-aluminium garnet single crystal was grown in the same manner as in Example 1, except that the nitrogen gas was supplied into the chamber at a flow rate of 2 L/min (outside the range of from 3 L/min or more to 6 L/min or less). As a result, a garnet single crystal was obtained without cracks, but desired shape and size were not obtained because it was difficult to control the temperature distribution in the furnace.

Next, as in Example 1, the obtained garnet single crystal was interposed between two polarizing plates orthogonal to each other for the observation. As a result, no cell growth was observed.

### Example 10

A terbium-scandium-aluminium garnet single crystal was grown in the same manner as in Example 1, except that the nitrogen gas was supplied into the chamber at a flow rate of 7 L/min (outside the range of from 3 L/min or more to 6 L/min or less). As a result, a garnet single crystal was obtained without cracks, but desired shape and size were not obtained because it was difficult to control the temperature distribution in the furnace.

Next, as in Example 1, the obtained garnet single crystal was interposed between two polarizing plates orthogonal to each other for the observation. As a result, no cell growth was observed.

### Example 11

A terbium-scandium-aluminium garnet single crystal was grown in the same manner as in Example 1, except that the seed crystal was pulled up under a condition where the pulling rate was 0.2 mm/h (outside the range of from 0.3 mm/h or more to 0.8 mm/h or less). Thus, a garnet single crystal having a maximum diameter of 25 mm and a length of 50 mm was obtained without cracks. Nevertheless, pulling the seed crystal at such a slow rate made the productivity of the garnet single crystal inferior.

Next, as in Example 1, the obtained garnet single crystal was interposed between two polarizing plates orthogonal to each other for the observation. As a result, no cell growth was observed.

### Comparative Example 5

A terbium-scandium-aluminium garnet single crystal was grown in the same manner as in Example 1, except that the seed crystal was pulled up under a condition where the pulling rate was 1.3 mm/h (outside the range of from 0.3 mm/h or more to 0.8 mm/h or less). Thus, a garnet single crystal having a maximum diameter of 25 mm and a length of 50 mm was obtained without cracks.

Next, as in Example 1, the obtained garnet single crystal was interposed between two polarizing plates orthogonal to each other for the observation. As a result, a cell growth was observed.

### Comparative Example 6

A terbium-scandium-aluminium garnet single crystal was grown in the same manner as in Example 1, except that the seed crystal was rotated under a condition where the number of rotations was 30 rpm (outside the range of from 5 rpm or more to 20 rpm or less). Thus, a garnet single crystal having a maximum diameter of 25 mm and a length of 50 mm was obtained without cracks.

Next, as in Example 1, the obtained garnet single crystal was interposed between two polarizing plates orthogonal to each other for the observation. As a result, a cell growth was observed.

### Example 12

A terbium-scandium-aluminium garnet single crystal was grown in the same manner as in Example 1, except that the seed crystal was rotated under a condition where the number of rotations was 5 rpm (a critical value in the range of from 5 rpm or more to 20 rpm or less). As a result, a garnet single crystal was obtained without cracks, but the crystal shape was distorted because it was difficult to control the crystal shape.

Next, as in Example 1, the obtained garnet single crystal was interposed between two polarizing plates orthogonal to each other for the observation. As a result, no cell growth was observed.

### Comparative Example 7

A terbium-scandium-aluminium garnet single crystal was grown in the same manner as in Example 1, except that the seed crystal was pulled up under a condition where the pulling rate was 1 mm/h (outside the range of from 0.3 mm/h or more to 0.8 mm/h or less). Thus, a garnet single crystal having a maximum diameter of 25 mm and a length of 50 mm was obtained without cracks.

Next, as in Example 1, the obtained garnet single crystal was interposed between two polarizing plates orthogonal to each other for the observation. As a result, a cell growth was observed.

### POSSIBILITY OF INDUSTRIAL APPLICATION

The terbium-scandium-aluminium garnet single crystal according to the present invention is transparent and does not have cracks and a cell growth portion. Thus, the terbium-scandium-aluminium garnet single crystal according to the present invention has such an industrial applicability that it is applicable as Faraday rotators for optical isolators in optical communications, fiber laser cutting machines, and so forth.

### [Reference Signs List]

- 1:: growth furnace
- 2:: chamber
- 3:: heat insulator
- 4:: pulling rod
- 5:: hot zone
- 6:: seed crystal
- 7:: garnet single crystal
- 8:: crucible
- 9:: raw-material melt
- 10:: RF coil
- 11:: crystal top portion
- 12:: crystal bottom portion

## Claims

1. A garnet single crystal **characterized in that** the garnet single crystal is represented by the following general formula:
(Tb₃₋ₓScₓ)(Sc_{2-y}Al_{y})Al₃O_{12-z} (1)
(where x satisfies 0.11≤x≤0.14, and y satisfies 0.17≤y≤0.23).

2. A method for producing a garnet single crystal using a growth furnace including a crucible in a cylindrical chamber by a Czochralski process for growing a garnet single crystal by bringing a seed crystal into contact with a raw-material melt in the crucible and pulling, while rotating, the seed crystal, **characterized in that** the production method comprises:
preparing the raw-material melt by filling the crucible with a mixture powder containing 20.9 to 21.2% by mole terbium oxide, 32.7 to 33.3% by mole scandium oxide, and the balance of aluminium oxide and unavoidable impurities, followed by melting of the mixture powder; and
growing the garnet single crystal according to claim 1, while supplying an inert gas into the chamber, by setting conditions such that the number of rotations of the seed crystal is 20 rpm or less, and a rate of pulling the seed crystal is 0.8 mm/h or less.

3. The method for producing a garnet single crystal according to claim 2, **characterized in that** the conditions are set such that
the number of rotations of the seed crystal is from 5 rpm or more to 20 rpm or less, and
the rate of pulling the seed crystal is from 0.3 mm/h or more to 0.8 mm/h or less.

4. The method for producing a garnet single crystal according to claim 2, **characterized in that** the inert gas is supplied into the chamber at a flow rate of from 3 L/min or more to 6 L/min or less.

5. The method for producing a garnet single crystal according to claim 3, **characterized in that** the inert gas is supplied into the chamber at a flow rate of from 3 L/min or more to 6 L/min or less.

6. The method for producing a garnet single crystal according to any one of claims 2 to 5, **characterized in that** the inert gas is a nitrogen gas.

## Patentansprüche

1. Granat-Einkristall **dadurch gekennzeichnet, dass** der Granat-Einkristall durch die folgende allgemeine Formel dargestellt ist:
(Tb₃₋ₓScₓ)(Sc_{2-y}Al_{y})Al₃O_{12-z} (1)
(in der x erfüllt 0,11≤x≤0,14 und y erfüllt 0,17≤y≤0,23).

2. Verfahren zur Herstellung eines Granat-Einkristalls unter Verwendung eines Wachstumsofens, der einen Schmelztiegel in einer zylinderförmigen Kammer beinhaltet, durch ein Czochralski-Verfahren zum Züchten eines Granat-Einkristalls durch in Kontakt bringen eines Impfkristalls mit einer Roh-Material-Schmelze in dem Schmelztiegel und Ziehen, während eines Drehens, des Impfkristalls, **dadurch gekennzeichnet, dass** das Herstellungsverfahren umfasst:
Erstellen der Roh-Material-Schmelze durch Füllen des Schmelztiegels mit einer Pulvermischung, die 20,9 bis 21,2 Mol-% Terbiumoxid, 32,7 bis 33,3 Mol-% Scandiumoxid, und den Rest an Aluminiumoxid und unvermeidbaren Verunreinigungen enthält, gefolgt von Schmelzen der Pulvermischung; und
Züchten des Granat-Einkristalls nach Anspruch 1, während des Zuführens eines Inertgases in die Kammer, durch Festlegen der Bedingungen derart, dass die Anzahl an Drehungen des Impfkristalls 20 rpm oder weniger ist und eine Rate des Ziehens des Impfkristalls 0,8 mm/h oder weniger ist.

3. Verfahren zur Herstellung eines Granat-Einkristalls nach Anspruch 2, **dadurch gekennzeichnet, dass** die Bedingungen derart festgelegt sind, dass
die Anzahl an Drehungen des Impfkristalls von 5 rpm oder mehr bis 20 rpm oder weniger ist und
die Rate des Ziehens des Impfkristalls von 0,3 mm/h oder mehr bis 0,8 mm/h oder weniger ist.

4. Verfahren zur Herstellung eines Granat-Einkristalls nach Anspruch 2, **dadurch gekennzeichnet, dass** das Inertgas bei einer Flussrate von 3L/min oder mehr bis 6 L/min oder weniger in die Kammer zugeführt wird.

5. Verfahren zur Herstellung eines Granat-Einkristalls nach Anspruch 3, **dadurch gekennzeichnet, dass** das Inertgas bei einer Flussrate von 3L/min oder mehr bis 6 L/min oder weniger in die Kammer zugeführt wird.

6. Verfahren zur Herstellung eines Granat-Einkristalls nach einem der Ansprüche 2 bis 5, **dadurch gekennzeichnet, dass** das Inertgas ein Stickstoffgas ist.

## Revendications

1. Monocristal de grenat **caractérisé en ce que** le monocristal de grenat est représenté par la formule générale suivante :
(Tb₃₋ₓSCₓ)(Sc_{2-y}Al_{y})Al₃O_{12-z} (1)
(où x satisfait 0,11 ≤ x ≤ 0,14, et satisfait y 0,17 ≤ y ≤ 0,23).

2. Procédé de production d'un monocristal de grenat à l'aide d'un four de croissance comprenant un creuset dans une chambre cylindrique par un procédé de Czochralski pour faire croître un monocristal de grenat en mettant un germe cristallin en contact avec une masse fondue de matière première dans le creuset et en tirant, tout en faisant tourner, le germe cristallin, **caractérisé en ce que** le procédé de production comprend :
la préparation de la masse fondue de matière première par remplissage du creuset avec un mélange en poudre contenant 20,9 à 21,2 % en moles d'oxyde de terbium, 32,7 à 33,3 % en moles d'oxyde de scandium, le reste étant de l'oxyde d'aluminium et des impuretés inévitables, suivi de la fusion du mélange en poudre ; et
la croissance du monocristal de grenat selon la revendication 1, tout en alimentant un gaz inerte dans la chambre, en fixant les conditions de telle sorte que le nombre de rotations du cristal germe soit de 20 tours par minute ou moins, et une vitesse de tirage du cristal germe soit de 0,8 mm/h ou moins.

3. Procédé de production d'un monocristal de grenat selon la revendication 2, **caractérisé en ce que** les conditions sont fixées de telle sorte que
le nombre de rotations du cristal germe soit de 5 tours par minute ou plus à 20 tours par minute ou moins, et
la vitesse de tirage du cristal germe soit de 0,3 mm/h ou plus à 0,8 mm/h ou moins.

4. Procédé de production d'un monocristal de grenat selon la revendication 2, **caractérisé en ce que** le gaz inerte est alimenté dans la chambre à un débit de 3 l/min ou plus à 6 l/min ou moins.

5. Procédé de production d'un monocristal de grenat selon la revendication 3, **caractérisé en ce que** le gaz inerte est alimenté dans la chambre à un débit de 3 l/min ou plus à 6 l/min ou moins.

6. Procédé de production d'un monocristal de grenat selon l'une quelconque des revendications 2 à 5, **caractérisé en ce que** le gaz inerte est un azote gazeux.
